# EUROPEAN PATENT SPECIFICATION

(11) **EP 0 248 883 B1**
(45) Date of publication and mention of the grant of the patent: **22.09.1993**
(21) Application number: 87900433.1
(22) Date of filing: 28.11.1986
(51) Int. Cl.: H01L 21/285, H01L 21/31, C23C 16/48

(54) **SELECTIVE DEPOSITION PROCESS**
SELEKTIVES NIEDERSCHLAGSVERFAHREN
PROCEDE DE DEPOT SELECTIF

(30) Priority: 05.12.1985 US 804727
(43) Date of publication of application: 16.12.1987
(73) Proprietor: NCR INTERNATIONAL INC., Dayton, Ohio 45479 (US)
(72) Inventor: METZ, Werner, Adam, Jr., Natick, MA 01760 (US); COLLINS, George, Joseph, Fort Collins, CO 80521 (US)
(74) Representative: Robinson, Robert George
(86) International application number: US8602568
(87) International publication number: WO8703741

(56) References cited:
- EP-A- 0 184 352
- EP-A- 0 194 109
- US-A- 4 543 270
- JAPANESE JOURNAL OF APPLIED PHYSICS, Supplements, 17th Conference on Solid State Devices and Materials, 25-27 August 1985, (Tokyo, JP), F. Uesugi et al. : "Direct writing of highly conductive Mo lines by laser induced CVD", pages 193-196.
- APPLIED PHYSICS LETTERS, volume 43, no. 10, November 1983, (New York, US), B.M. McWilliams et al. : "Wafer-scale laser pantography : Fabrication of n-metal-oxide-semiconductor transistors and small-scale integrated circuits by direct-write laser-induced pyrolytic reactions", pages 946-948.

## Description

### Technical Field

This invention relates to a process for selectively depositing a film of a particular material on a substrate.

The invention has a particular application to the field of selectively depositing a metal film, such as tungsten, during fabrication of a semiconductor device. In particular, the invention finds use in the fabrication of VLSI semiconductor devices in which the resistivity of doped polycyrstalline silicon, the commonly used lower level interconnect and electrode material, is too great for the speeds or power consumption levels required. A layer of high conductivity material, for instance tungsten, provided on the polycyrstallic silicon, alleviates this problem.

### Background Art

An article in SOLID STATE TECHNOLOGY, June 1985, pages 220-227; Solanki et al: "Laser-Induced Chemical Vapor Deposition", discloses the laser-induced deposition of thin films by pyrolysis, evaporation and photolysis. When utilizing pyrolysis, a laser beam is directed onto a substrate to heat the substrate locally in the beam area. The laser wavelength is chosen such that it is absorbed by the substrate and is transparent to the reactant gases. Since the deposition area is related to beam size, this technique is inefficient for use in a volume production process.

U.S. Patent No. 4,395,433 discloses a process wherein a silicon dioxide film is formed on a substrate and etched to expose an area of the substrate surface. The structure is placed in a reaction chamber at a temperature of 600°C and exposed to silane gas. In one arrangement, a laser beam is applied to the whole substrate surface. Silicon is deposited on the exposed surface of the substrate but not on the insulating film because the relatively high thermal conductivity of the substrate conducts heat away from the substrate surface, whereas the relatively low thermal conductivity of the silicon dioxide causes heat to concentrate at the surface thereof, such that silicon to be deposited is scattered, failing to form a silicon layer.

The document Japanese Journal of Applied Physics, Supplements, 17th Conference on Solid State Devices and Materials, 25-27 August 1985, (Tokyo, JP), F. Uesugi et al.: "Direct writing of highly conductive Mo lines by laser induced CVD" pages 193-196, discloses a process for the direct writing of molybdenum lines on a silicon dioxide coated silicon substrate. Firstly, an initial photochemical deposition of molybdenum is effected utilizing a 257 nm argon laser. Secondly, a 515 nm argon laser beam is focused on the initial deposit to start photothermal deposition of molybdenum. This 515 nm laser beam is then scanned across the substrate (by supporting the substrate on a computer controlled X-Y translation table) whereby continuous writing of molybdenum lines is effected by lateral direction film growth.

The document Applied Physics Letters, volume 43, no. 10, November 1983, (New York, US), B.M McWilliams et al.: "Wafer-scale laser pantography: Fabrication of n-metaloxide-semiconductor transistors and small-scale integrated circuits by direct-write laser-induced pyrolytic reactions", pages 946-948, discloses the direct laser writing, using a focused laser beam, such as a pulsed argon laser, of various features on a semiconductor substrate. The substrate is supported on an X-Y translation table. The focused laser beam may be used to deposit polysilicon gate electrodes coated with a tungsten overlayer. The direct writing of tungsten lines is also disclosed, using laser-induced pyrolytic reduction of tungsten hexafluoride.

### Disclosure of the Invention

It is an object of the present invention to provide an efficient process for the selective deposition of a material on a substrate surface.

Therefore, according to the present invention, there is provided a process of selectively depositing a film of a particular material on a substrate, characterized by the steps of providing selected regions of doped semiconductor material on the substrate said selected regions having accentuated radiation absorption characteristics at a selected wavelength; subjecting the substrate to an environment containing a gaseous compound which is adapted to pyrolytically deposit a film of said particular material on a region of elevated temperature while blanket exposing the entire surface of the substrate to radiation at the wavelength for which the radiation absorption characteristics of the selected regions of doped semiconductor material are accentuated; and blanket exposing the substrate with said radiation until said selected regions of doped semiconductor material are sufficiently elevated in temperature to cause a localised pyrolytic reaction of said gaseous compound, so as to selectively deposit a film of said particular material on said selected regions of doped semiconductor material only.

According to one practice of the invention, collimated coherent photon energy, commonly in the form of a laser beam, is used to blanket illuminate the upper surface of a partially completed semiconductor substrate while the substrate is situated within a reactant gas environment. The wavelength of the laser, the composition of the reactant gas, and the composition of the various regions of the exposed surface of the substrate are selected to ensure that photon energy absorption rate is materially greater in those regions where pyrolytic reaction is intended. The amorphous or polycrystalline silicon regions of accentuated absorption are selectively heated to elevate the local temperate and initiate a pyrolytic reaction with the metal bearing gaseous compound ambient, while the adjacent lower temperature regions are substantially unaffected. Thereby, the pyrolytic deposition of the metals coincides with the pattern of the high photon energy absorption coefficient silicon. The selectivity of the photon absorption can be further accentuated by matching the wavelength of the photon energy source and the thicknesses of the selected regions to adjust the optical reflection or absorption, or by changing the wafer temperature to alter the optical free carrier absorption.

According to an alternate embodiment, the selectivity, namely the differences in photon absorption coefficient, is further accentuated by aligning the collimated photon energy beam to be precisely perpendicular to the surface of the region having high photon energy absorption characteristics. The use of a short pulse duration photon energy source then localizes the regions of elevated temperature to the upper surface of the layer. Thereby, pyrolytic reaction and the associated spatially selective deposition is limited to the upper surface of the selected substrate regions. Upper surface selectivity can be enhanced by using very short wavelength, short pulse duration photon energy sources and by altering the photon energy absorption characteristics of the upper surface relative to the bulk of the patterned region. Typically, this would involve a surface doping for a silicon semiconductor by shallow ion implantation or the like. Optical free carrier absorption in such doped regions would be materially larger than for undoped regions.

The use of these concepts allows one to deposit, with a high degree of spatial selectivity, low resistance shunting materials such as tungsten onto patterned amorphous or polycrystalline silicon, either on the whole or on merely the top surfaces thereof, for gate electrodes or interconnect electrodes of integrated circuit devices. The process can also be applied to selectively deposit on exposed monocrystalline silicon, such as in the heavily doped source/drain regions of field effect transistors, or on the polycrystalline silicon gate electrode layers. Furthermore, the selectivity can be practiced in such a way as to avoid undesired pyrolytic deposition of refractory metal on the undoped or very lightly doped regions which are intended to remain of high resistance.

### Brief Description of the Drawings

Fig. 1 is a schematic cross-section of a field effect transistor structure in which the accentuated photon energy absorption of the gate electrode is employed to pyrolytically deposit a metallic layer thereover.

Fig. 2 is a schematic similar to that in Fig. 1, wherein the thickness of the gate electrode is matched to the wavelength of the photon energy.

Fig. 3 depicts another arrangement for spatially selective deposition, the figure diagrammatically depicts the use of a short wavelength pulsed photon energy source collimated and aligned to limit the pyrolytic reaction to the upper surface of the gate electrode.

Fig. 4 schematically illustrates the use of a thin doped region at the surface of a polycrystalline silicon gate electrode layer to spatially control the deposition to the upper surface via the significantly higher optical free carrier absorption in this region.

Fig. 5 schematically depicts a field effect transistor structure in which spatially selective deposition by photon energy absorption coefficient differences is used to selectively deposit a metal over the source/drain regions and gate electrode while avoiding gate to source/drain shorts over the sidewall oxides.

Fig. 6 schematically illustrates the structure in Fig. 5 extended to include a high resistance polycrystalline silicon region, which by selectivity of the photon absorption coefficient is not subject to a pyrolytic deposition. Low free carrier absorption occurs because of the low doping levels.

Fig. 7 is a schematic illustrating apparatus suitable to practice the spatially selective deposition process to which this invention pertains.

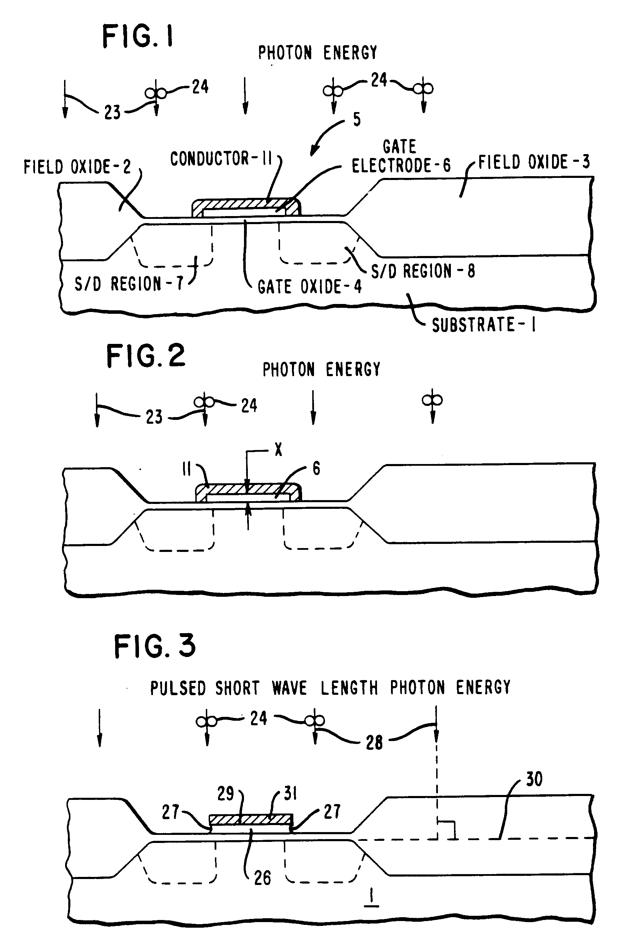

One aspect of the invention may be appreciated by considering the field effect transistor application depicted in Fig. 1 of the drawings. According to that practice, a semiconductor substrate 1 comprised of a material such as monocrystalline silicon is processed according to known techniques to form spaced-apart field oxide regions 2 and 3, preferably composed of 500-1000 nanometers thick silicon dioxide. The active region 5 of substrate 1 situated between field oxides 2 and 3 is covered by gate oxide 4, preferably composed of silicon dioxide to a thickness in the range of 20 to 50 nanometers. Situated over the gate oxide 4 and generally centrally within the exemplary active region is gate electrode 6, typically patterned from doped polycrystalline silicon and having a thickness in the range of 30 to 50 nanometers. On either the side of gate electrode 6 and within the structure of substrate 1 are regions 7 and 8 generally representing the transistor source and drain electrodes. The practice of the invention as depicted in Fig. 1 is directed to forming a spatially selective deposition of low resistance, shunting, conductive layer 11 which fully encloses gate electrode 6 while eliminating spurious formations of the conductive material (forming conductor 11) on gate oxide 4 or field oxide regions 2 or 3, wherein the practice thereof obviates the use of photolithographic masking. Optical free carrier absorption which is much stronger in heavily doped regions will encourage selective heating and hence selective deposition.

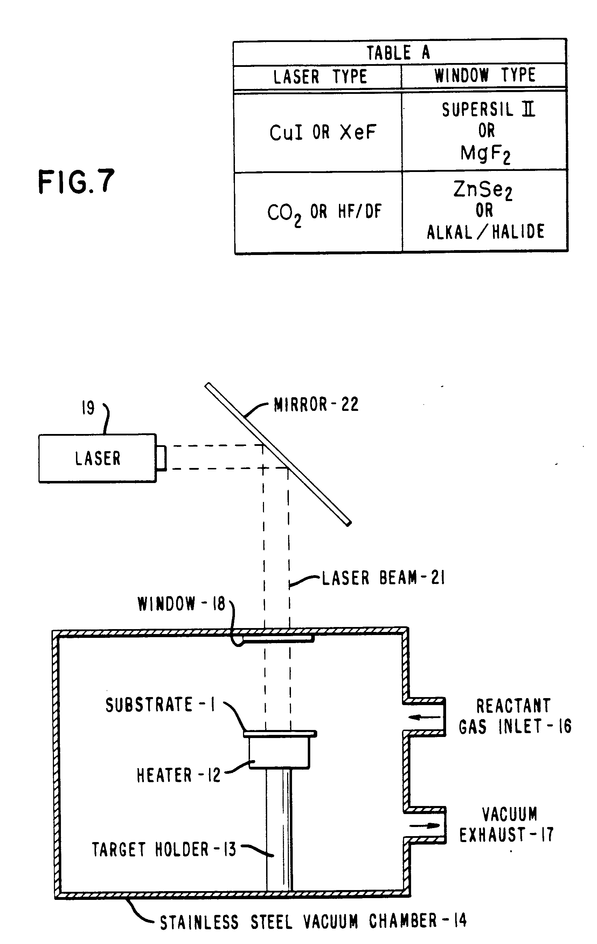

Following one practice of the invention, as schematically depicted in Fig. 7, substrate 1 is situated on heater 12 and fixed by target holder 13 within vacuum chamber 14. The heater provides a temperature bias to optimize selectively in the free carrier absorption. Reactant gases enter the chamber by inlet 16, and the residuals thereof are removed by vacuum level exhaust 17. One wall of vacuum chamber 14 includes a photon energy transmissive window 18, the composition of which is selected to match the fundamental wavelength of the coherent photon energy beam provided, in this case, by laser 19. Laser beam 21 is shown according to this embodiment to be directed through window 18 by reflection off mirror 22. Table A sets forth suitably wavelength matched sets of laser types and window materials.

Applying the apparatus shown in Fig. 7 to the processing of the substrate 1 in the form depicted in Fig. 1, it is possible to selectively deposit conductive layers such as 11 in Fig. 1, preferably composed of a refractory metal such as tungsten, onto the exposed surfaces of a patterned polycrystalline silicon layer, such as gate electrode 6. The selectivity of the pyrolytic reaction by which conductor 11 is deposited is attributable to a number of process conditions. First, the wavelength of the coherent photon energy is matched to the selective photon absorption wavelength of polycrystalline silicon gate electrode 6, while being of such wavelength that field oxides 2 and 3, gate oxide 4 and monocrystalline silicon substrate 1 are substantially transparent thereto. Alternatively, the combination of the substrate temperature and localized doping can cause selective absorption of free carriers. Additionally, the wavelength of the photon energy 23 is selected to minimize absorption by reactant gases 24 through which the photon energy beam is projected. A specific set of parameters by which such process may be practiced will be introduced at a later point.

The central processing feature which Fig. 1 conveys is the application of selective photon energy absorption to initiate spatially selective, localized, pyrolysis in the pursuit of selectively depositing materials created by the pyrolytic reaction. The source of the photon energy 23 for the practice of the deposition depicted in Fig. 1 is either a CW or a pulsed laser providing a blanket illumination of substrate 1.

Fig. 2 of the drawings depicts a variation to the invention described with reference to Fig. 1, wherein photon energy 23 is further matched to accentuate the selective absorption characteristics of gate electrode 6. According to this embodiment, the thickness "X" of gate electrode 6 is selected to be a multiple of one-fourth the wavelength of the coherent photon energy source, the laser. The thickness of gate electrode 6 would then have an optical path length which maximized absorption for internally reflected photon energy. The temperature rise of gate electrode 6 would thereby be maximized for the energy received. In contrast, the thicknesses of the regions which preferably transmit or reflect photon energy 23 would be selected to be multiples of one-half the photon energy wavelength, to minimize energy absorption. Again, conductive layer 11 would be selectively deposited by the temperature responsive pyrolytic reaction of gases 24 in the immediate proximity of gate electrode 6.

A further variation to the fundamental concept depicted in Fig. 1 is schematically represented in Fig. 3. In this case, polycrystalline silicon gate electrode 26 is patterned to have substantially vertical sidewalls, photon energy beam 28 is collimated in a direction substantially perpendicular to plane 30 of substrate 1, and the photon energy source is of pulsed rather than continuous wave character. For instance, a laser operating in the ultraviolet radiation wavelength region and with a pulse duration of 10 nanoseconds or less and a repetition rate of 100-500 pulses per second or less will provide further absorption selectivity or localization, in this case limiting the pyrolytic temperature to upper surface 29 of polycrystalline silicon gate electrode 26. Under such conditions, the photon energy heating is limited to the top 100 nanometers of gate electrode 26. The pulse duration and repetition rate ensures that heat generated at the surface is sufficient to support pyrolysis, yet inadequate to materially elevate the temperature of the bulk substate. Therefore, only the surface 29 of gate electrode 26 acquires the temperature necessary to initiate pyrolytic reaction with reactant gases 24, and the selective deposition of conductor layer 31 is so limited.

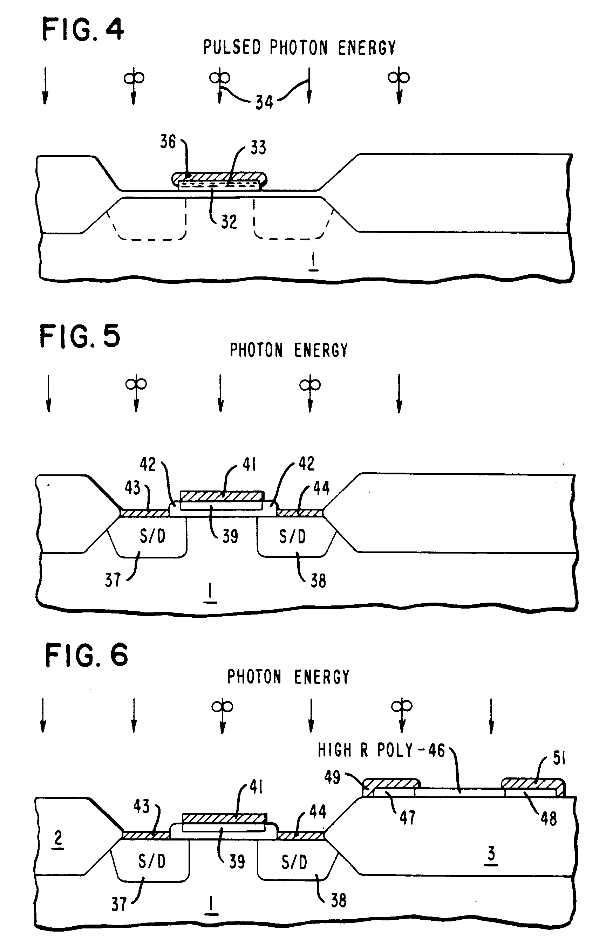

Another technique for providing enhanced spatial selectivity, where again the desire is to limit conductor deposition to the top surface such as depicted in Fig. 4, employs the combined use of a pulsed photon energy source with a non-uniformly doped polycrystalline silicon layer. According to one practice, patterned polycrystalline silicon layer 32 is doped, by diffusion or ion implantation, to have a significantly higher impurity concentration 33 at the upper surface than exists deeper within the gate electrode 32. The structure is then subjected to pulsed photon energy at the infrared radiation end of the spectrum. The doped surface region photon absorption characteristics at such wavelengths due to free carrier absorption are materially greater than the absorption characteristics of the undoped sidewall. If the photon energy source 34 is pulsed with a pulse duration and repetition rate suitable to minimize heat transfer to the bulk substrate 1, the temperature rise, pyrolitic reaction, and deposition will be localized to the upper surface region 33 of gate electrode 32. It will no doubt be appreciated that this technique can be combined with that described with reference to Fig. 3 to further control the deposition pattern of the conductor, such as upper surface conductor 36 on gate electrode 32 in Fig. 4.

The various techniques and refinements described with reference to Figs. 1-4 can also be applied to selectively deposit conductive materials on heavily doped source/drain regions of field effect transistors, such as regions 37 and 38 depicted in Fig. 5. According to this practice of the invention, gate electrode 39 has deposited thereupon a shunting conductive layer 41 and remains electrically isolated by sidewall silicon dioxide regions 42 from similarly overlying conductive layers 43 and 44, respectively shunting source/drain regions 37 and 38. A background discussion of this field effect transistor structure appears in U.S. Patent No. 4,503,601.

A further refinement of the process to which this invention pertains leads to the structure depicted in Fig. 6. As shown in Fig. 6, field oxide region 3 has formed thereupon a composite polycrystalline silicon layer 46-47-48 configured to perform the function of a resistor. Resistive region 46 can be intrinsic polycrystalline silicon or polycrystalline silicon lightly doped in situ or by post-formation implant, and is connected at either end to heavily doped polysilicon interconnect regions 47 and 48. By applying the concepts of optical free carrier absorption to selectively heat a designated pattern and thereby initiate spatially localized pyrolysis and deposition, conductive layers 41, 43, 44, 49 and 51 are formed respectively over heavily doped polycrystalline silicon gate electrode 39, heavily doped monocrystalline silicon source/drain regions 37 and 38, and heavily doped polycrystalline silicon interconnect regions 47 and 48, while lightly doped or undoped polycrystalline silicon layer 46 remains uncovered to retain its resistive character.

The practice of the particular features which characterize the present invention to create the structure depicted in Fig. 5 follows the formation of source/drain regions 37 and 38 associated sidewall silicon dioxide regions 42-42, for example in accordance with the practice set forth in U.S. Patent No. 4,503,601. Thereafter, substrate 1 is inserted in chamber 14 (Fig. 7) and elevated to a temperature of approximately 100-300°C by heater 12. The chamber is evacuated to maintain a pressure in the range between 13.3 Pa (0.1 Torr) and 133 Pa (1 Torr) by a vacuum pump connected to exhaust 17. A 1:5 to 1:200 mixture by volume of WF₆ and H₂ is introduced into the chamber through gas inlet 16 while maintaining the prescribed chamber pressure. Beam 21 is then generated by to have a power of 50 watts and a beam cross section of 1 cm² at the substrate surface for a CuI laser operable at 510 nanometers (green), or at a power of 50 watts and a beam cross section of 5 cm² for a XeF laser operable at 358 nanometers (uv), and projected through window 18 comprised of either SUPERSIL II or MgF₂. Both wavelengths are transparent to the WF₆ reactant gas and provide photon energy which is selectively absorbed by silicon. Furthermore, both wavelengths of photon energy are transparent to silicon dioxide, and as such, ensure that any photons impinging on substrate 1 at locations other than the polycrystalline silicon gate electrode 39 or monocrystalline silicon source/drain regions 37 and 38 are transmitted into and absorbed by the bulk substrate. In contrast, the photons illuminating silicon regions 37, 38 and 39 elevate the local region temperatures sufficiently to initiate pyrolysis, and locally disassociate the tungsten from the reactant gas mixture to deposit it directly on the locally heated silicon. A nominal 100 nanometer thick deposition will result if the CuI or XeF lasers are used for approximately 5-10 minutes.

The further selective deposition as depicted in Fig. 6 of the drawings may be practiced with CO₂ or HF/DF lasers operating, respectively, at 10.6 and 3 micrometers wavelengths, 500 and 300 watts, and 10 cm² beam areas. In such cases, the apparatus depicted in Fig. 7 elevates the substrate to a temperature of approximately 400-600°C. Preferably, the chamber pressure is maintained at approximately 26.6 Pa (0.2 Torr) while a 1:5 to 1:200 mixture by volume of WF₆ and H₂ reactant gas is being supplied. The substrate is illuminated for approximately 1-5 minutes with the CO₂ laser and approximately 2-8 minutes with the HF/DF laser to deposit tungsten layers 41, 43, 44, 49 and 51 of approximately 100 nanometers thick over monocrystalline source/drain regions 37 and 38, and heavily doped polycrystalline silicon regions 39, 47 and 48. Note, however, that intrinsic or lightly doped polycrystalline silicon region 46 remains uncovered. This ability to differentiate between doped and undoped silicon regions is unique to the spatially selective free carrier absorption technique of the present invention. In addition, the absorption depth of the free carriers is amenable to further variation in relation to the bias temperature of the substrate. Conventionally practiced techniques for the selective deposition of tungsten are unable to differentiate, and would, consequently deposit a shunting tungsten layer over all exposed polycrystalline or monocrystalline silicon regions.

The onset of pyrolysis and selective deposition of the conductive layer, preferably refractive tungsten, inherently alters the selective photon absorption characteristics of the region upon which it forms. For tungsten deposited to form the structure depicted in Fig. 5 using a CuI or XeF laser, the tungsten layer is self-limited to approximately 100 nanometers in thickness. Nevertheless, the metallic films or layers formed by selective pyrolysis according to the present invention form nucleation centers for subsequent, more conventional chemical vapor depositions of the conductive layers to greater thicknesses. For instance, when tungsten is the refractory metal being deposited and the selective pyrolysis deposition is self-limited to approximately 100 nanometers, the nucleation center characteristics of the thin tungsten layer allows for subsequent selective CVD deposition of tungsten in substantially conventional manner to a combined thickness of approximately 1 micrometer.

It should be understood that the concepts which are central to the present invention are not limited to applications involving monocrystalline or polycrystalline silicon semiconductors, but are applicable with equal effect to structures employing amorphous silicon regions as sites for pryolitic reaction. In like manner, the concepts of the present invention are applicable to other semiconductor materials used in the fabrication of intergrated circuit devices, including but not limited to gallium arsenide, indium phosphide, aluminum gallium arsenide, and indium gallium aluminum phosphide.

## Claims

1. A process of selectively depositing a film of a particular material on a substrate (1), characterized by the steps of providing selected regions (6,26,33,37,38,39,47,48) of doped semiconductor material on the substrate (1), said selected regions having accentuated radiation absorption characteristics at a selected XXc wavelength; subjecting the substrate (1) to an environment containing a gaseous compound which is adapted to pyrolytically deposit a film of said paticular material on a region of elevated temperature while blanket exposing the entire surface of the substrate (1) to radiation at the wavelength for which the radiation absorption characteristics of the selected regions (6,26,33,37,38,39, 47,48) of doped semiconductor material are accentuated; and blanket exposing the substrate (1) with said radiation until said selected regions (6,26,33,37,38,39,47,48) of doped semiconductor material are sufficiently elevated in temperature to cause a localized pyrolytic reaction of said gaseous compound, so as to selectively deposit a film of said particular material on said selected regions (16,26,33,37,38,39,47,48) of doped semiconductor material only.

2. A process according to claim 1, characterized in that the radiation is collimated, aligned to be substantially perpendicular to the plane of the illuminated surface of the substrate (1), and pulsed.

3. A process according to claim 1 or claim 2, characterized by the further step of: subjecting the substrate (1) to a chemical vapour deposition in which said particular material deposited by the localised pyrolytic reaction serves as a nucleation region for said chemical vapour deposition.

4. A process according to any one of the preceding claims, characterized in that the radiation is comprised of coherent photons generated by a laser.

5. A process according to any one of the preceding claims, characterized by the step of heating said substrate (1) while effecting said blanket exposure.

6. A process according to claim 1, characterized in that said selected regions (6,26,33,39,47,48) of doped semiconductor material having accentuated photon energy absorption characteristics, include polycrystalline or amorphous silicon.

7. A process according to any one of the preceding claims, characterized in that the deposited, particular material is a refractory metal.

8. A process according to claim 7, characterized in that said refractory metal is tungsten.

9. A process according to claim 8, characterized in that said gaseous compound is tungsten hexafluoride.

## Patentansprüche

1. Verfahren zum selektiven Niederschlagen einer Schicht aus einem speziellen Material auf ein Substrat (1), gekennzeichnet duruch die Schritte: Bereitstellen ausgewählter Gebiete (6, 26, 33, 37, 38, 39, 47, 48) mit dotiertem Halbleitermaterial auf dem Substrat (1), wobei die ausgewählten Gebiete erhöhte Strahlungsabsorptionskennwerte bei einer ausgewählten Wellenlänge aufweisen; Aussetzen des Substrats (1) einer Umgebung, die eine gasförmige Verbindung aufweist, die zum pyrolytischen Niederschlagen einer Schicht aus dem speziellen Material auf einem Gebiet mit erhöhter Temperatur geeignet ist, während die gesamte Fläche des Substrats (1) einer Strahlung mit einer Wellenlänge insgesamt ausgesetzt wird, bei der die Strahlungsabsorptionskennwerte der ausgewählten Gebiete (6, 26, 33, 37, 38, 39, 47, 48) mit dotiertem Halbleitermaterial erhöht sind; und Belichten des gesamten Substrats (1) mit der Strahlung, bis die ausgewählten Gebiete (6, 26, 33, 37, 38, 39, 47, 48) mit dotiertem Halbleitermaterial eine ausreichende Temperaturerhöhung aufweisen, um eine örtlich beschränkte pyrolytische Reaktion der gasförmigen Verbindung hervorzurufen, so daß eine Schicht aus dem speziellen Material nur selektiv auf den ausgewählten Gebieten (6, 26, 33, 37, 38, 39, 47, 48) mit dotiertem Halbleitermaterial abgeschieden wird.

2. Verfahrern nach Anspruch 1, dadurch gekennzeichnet, daß die Strahlung kollimiert, im wesentlichen senkrecht zur Ebene der belichteten Fläche des Substrats (1) ausgerichtet und gepulst ist.

3. Verfahren nach Anspruch 1 oder 2, gekennzeichnet durch den weiteren Schritt: Aussetzen des Substrats (1) einer chemischen Gasphasenabscheidung, bei der das durch die örtlich beschränkte, pyrolytische Reaktion abgeschiedene, spezielle Material als ein Kernbildungsgebiet für die chemische Gasphasenabscheidung dient.

4. Verfahren nach einem der vorhergehenden Ansprüche, dadurch gekennzeichnet, daß die Strahlung aus kohärenten Photonen besteht, die von einem Laser erzeugt werden.

5. Verfahren nach einem der vorhergehenden Ansprüche, gekennzeichnet durch den Schritt: Aufheizen das Substrats (1), während die Gesamtbelichtung durchgeführt wird.

6. Verfahren nach Anspruch 1, dadurch gekennzeichnet, daß die ausgewählten Gebiete (6, 26, 33, 39, 47, 48) mit dotiertem Halbleitermaterial, die erhöhte Photonenenergie-Absorptionskennwerte aufweisen, polykristallines oder amorphes Silizium aufweisen.

7. Verfahren nach einem der vorhergehenden Ansprüche, dadurch gekennzeichnet, daß das abgeschiedene, spezielle Material ein Refraktär-Metall ist.

8. Verfahren nach Anspruch 7, dadurch gekennzeichnet, daß das Refraktär-Metall Wolfram ist.

9. Verfahren nach Anspruch 8, dadurch gekennzeichnet, daß die gasförmige Verbindung Wolframhexafluorid ist.

## Revendications

1. Procédé pour déposer sélectivement un film d'une matière particulière sur un substrat (1), caractérisé par les étapes qui consistent à prévoir des régions choisies (6, 26, 33, 37, 38, 39, 47, 48) d'une matière semiconductrice dopée sur le substrat (1), lesdites régions choisies ayant des caractéristiques accentuées d'absorption de rayonnement à une longueur d'onde choisie ; à soumettre le substrat (1) à un environnement contenant un composé gazeux qui est conçu pour déposer par voie pyrolytique un film de ladite matière particulière sur une région de température élevée tout en exposant de façon générale la totalité de la surface du substrat (1) à un rayonnement à la longueur d'onde pour laquelle les caractéristiques d'absorption de rayonnement des régions choisies (6, 26, 33, 37, 38, 39, 47, 48) de matière semiconductrice dopée sont accentuées ; et à exposer de façon générale le substrat (1) audit rayonnement jusqu'à ce que lesdites régions choisies (6, 26, 33, 37, 38, 39, 47, 48) de matière semiconductrice dopée soient suffisamment élevées en température pour provoquer une réaction pyrolytique localisée dudit composé gazeux afin de déposer sélectivement un film de ladite matière particulière seulement sur lesdites régions choisies (16, 26, 33, 37, 38, 39, 47, 48) de matière semiconductrice dopée.

2. Procédé selon la revendication 1, caractérisé en ce que le rayonnement est collimaté, aligné de façon à être sensiblement perpendiculaire au plan de la surface illuminée du substrat (1) et pulsé.

3. Procédé selon la revendication 1 ou la revendication 2, caractérisé par l'autre étape qui consiste à soumettre le substrat (1) à un dépôt chimique en phase vapeur dans lequel ladite matière particulière déposée par la réaction pyrolytique localisée sert de région de nucléation pour ledit dépôt chimique en phase vapeur.

4. Procédé selon l'une quelconque des revendications précédentes, caractérisé en ce que le rayonnement est constitué de photons cohérents générés par un laser.

5. Procédé selon l'une quelconque des revendications précédentes, caractérisé par l'étape qui consiste à chauffer ledit substrat (1) pendant que l'on effectue ladite exposition générale.

6. Procédé selon la revendication 1, caractérisé en ce que lesdites régions choisies (6, 26, 33, 37, 38, 39, 47, 48) de matière semiconductrice dopée, ayant des caractéristiques accentuées d'absorption d'énergie des photons, comprennent du silicium polycristallin ou amorphe.

7. Procédé selon l'une quelconque des revendications précédentes, caractérisé en ce que ladite matière particulière déposée est un métal réfractaire.

8. Procédé selon la revendication 7, caractérisé en ce que ledit métal réfractaire est du tungstène.

9. Procédé selon la revendication 8, caractérisé en ce que ledit composé gazeux est de l'hexafluorure de tungstène.
